# EUROPÄISCHE PATENTSCHRIFT

(11) **EP 0 653 613 B1**
(45) Veröffentlichungstag und Bekanntmachung des Hinweises auf die Patenterteilung: **26.11.1997**
(21) Anmeldenummer: 94116151.5
(22) Anmeldetag: 13.10.1994
(51) Int. Cl.: G01J 1/42

(54) **UV-Sensor**
UV sensor
Senseur de rayons ultraviolets

(30) Priorität: 29.09.1994 DE 4434858; 12.11.1993 DE 4338807
(43) Veröffentlichungstag der Anmeldung: 17.05.1995
(73) Patentinhaber: Xenotest Gesellschaft für die Herstellung von Materialprüfgeräten mbH, 63589 Linsengericht/Altenhasslau (DE)
(72) Erfinder: Krönert, Dr. Uwe, D-63486 Bruchköbel (DE); Kellner, Frank, D-63546 Hammersbach (DE); Rudolph, Bernd, D-63755 Alzenau (DE)
(74) Vertreter: Schumacher, Bernd, Dipl.-Ing.

(56) Entgegenhaltungen:
- DE-A- 3 902 028
- PATENT ABSTRACTS OF JAPAN vol. 10, no. 245 (C-368) 22. August 1986 & JP-A-61 076 547 (TEIJIN CHEM LTD ET AL.) 19. April 1986
- PATENT ABSTRACTS OF JAPAN vol. 14, no. 238 (P-1050) 21. Mai 1990 & JP-A-02 061 524 (TOKAI UNIV. ET AL.) 1. März 1990

## Beschreibung

Die Erfindung betrifft einen UV-Sensor mit einem eine Eintrittsöffnung für die UV-Strahlung aufweisenden Gehäuse, in dem ein Fotodetektor für die Messung der durch die Eintrittsöffnung einfallenden UV-Strahlung angeordnet ist und mit einem, in Richtung der einfallenden UV-Strahlung vor dem Fotodetektor angeordnetem, SiO₂-haltigen Streuelement.

UV-Strahler oder -Laser werden beispielsweise bei der Aushärtung von Lacken, bei der photolytisch unterstützten Abscheidung von Beschichtungsmaterialien, bei der Entkeimung von Oberflächen, Flüssigkeiten und Gasen sowie bei Alterungs- und Verwitterungsversuchen eingesetzt.

Zur Messung der UV-Strahlendosis und zur Überwachung der Funktionsfähigkeit der UV-Strahlenquellen werden üblicherweise UV-Sensoren verwendet.

Bei der Messung der UV-Strahlung ergibt sich hinsichtlich des Sensormarterials das Problem, daß die energiereiche UV-Strahlung Strahlenschäden verursachen kann. Hinsichtlich der Meßgenauigkeit stellt sich bei vielen Anwendungen die Aufgabe, aus allen Richtungen auf den UV-Sensor fallende Strahlen bei der Messung möglichst zu berücksichtigen.

Ein gattungsgemäßer UV-Sensor ist aus der DE- A1 39 02 028 bekannt. Dieser besteht aus einem zylindrischen Gehäuse, in dem eine Vakuumfotozelle mit Cäsiumchlorid-Fotokathode befestigt ist. Das Gehäuse weist eine Eintrittsöffnung für einfallende UV-Strahlung auf, die von einer Lochplatte teilweise verschlossen ist. Die Lochplatte dient zur Reduzierung der Intensität des einfallenden UV-Lichtes. Zwischen der Lochplatte und der Fotozelle ist ein Streuelement in Form einer Streuscheibe vorgesehen. Diese besteht aus polykristallinem Quarz, vorzugsweise aus Quarzfritte.

Die Streuscheibe sorgt für eine diffuse Lichtstreuung. Diese bewirkt einerseits eine weitere Abschwächung des auf die Fotozelle auftreffenden Lichtes, andererseits gewährleistet die diffuse Lichtstreuung eine gewisse Unabhängigkeit der Messung von der Richtung des einfallenden UV-Lichtes. Die Diffusuvität der Streuscheibe beruht auf der Streuung des UV-Lichtes an den Korngrenzen des Quarzkristalle, bzw. an den Partikelgrenzen der Quarzfritte. Die Streueigenschaften der Streuscheibe hängen somit von der Korngrößenverteilung des verwendeten Quarzmaterials und im wesentlichen aber auch von ihren Herstellungsbedingungen ab. So bewirkt beispielsweise eine sehr hohe Sintertemperatur das Verschwinden von Korngrenzen und eine Erhöhung der Transmissivität der Streuscheibe. Bei einer geringen Sintertemperatur dagegen ist die Lichtdämpfung der Streuscheibe höher und Ihre Transmissivität geringer, wobei auch die Gefahr besteht, daß zwischen den einzelnen Teilchen der Glasfritte verbleibende offene Poren die Gasdichtigkeit der UV-Sensoren beeinträchtigen. Da Quarzkristall hinsichtlich der Lichtführung und Lichtbrechung kein isomorphes Material darstellt, hängen die Streueigenschaften der bekannten Streuscheibe auch von der zufälligen Orientierung der Quarzkörnung ab. Die Reproduzierbarkeit der Streuscheibe hinsichtlich ihrer optischen Eigenschaften, ihrer Festigkeit und ihrer Dichtigkeit ist daher nur schwer zu gewährleisten. Wegen ihrer geringen Festigkeit ist die Streuscheibe des bekannten UV-Sensors nach dem Sintern nur mit Vorsicht zu handhaben und kaum noch mechanisch bearbeitbar. Hinzu komt, daß sich in den auf der Oberfläche der Streuscheibe verbleibenden offenen Poren Schmutzpartikel ansammeln, die nur schwer wieder zu entfernen sind, so daß die Transmissivität der Streuscheibe mit der Zeit undefinierbar abnimmt. Dazu tragen auch Materialschädigungen bei, die aufgrund der energiereichen UV-Strahlung in der kristallinen Kristallfritte induziert werden.

Der vorliegenden Erfindung liegt somit die Aufgabe zugrunde, einen UV-Sensor anzugeben, der über längere Zeit stabile und reproduzierbare Meßergebnisse liefert und der einfach und wirtschaftlich herstellbar ist.

Diese Aufgabe wird ausgehend vom dem eingangs genannten Sensor dadurch gelöst, daß das Streuelement Quarzglas enthält, mit inneren Grenzflächen, deren Orientierung im Raum statistisch homogen verteilt ist. Quarzglas ist für UV-Strahlung im Wellenlängenbereich zwischen 300 nm und 400 nm durchlässig. Quarzglas ist ein homogener, amorpher Werkstoff; es weist keine Korngrenzen auf. Dadurch werden die mit Korngrenzen verbundenen Nachteile der Streuscheiben der bekannten UV-Sensoren vermieden. So weist bespielsweise ein Streuelement in Form einer Scheibe aus Quarzglas eine hohe mechanische Festigkeit auf, das auch maschinell nachbearbeitbar ist. Das Quarzglas gewährleistet eine hohe Strahlenbeständigkeit des Streuelementes gegenüber UV-Strahlung; Materialschädigungen werden bei Quarzglas erst bei sehr hohen Energiedichten der UV-Strahlung beobachtet. Schutzelemente für das Streuelement zur Reduzierung der Energiedichte der auftreffenden UV-Strahlung sind daher nicht erforderlich. Das Streuelement aus amorphem Quarzglas ist gasdicht herstellbar (abgesehen von den durch Quarzglas diffundierenden Gasen Wasserstoff und Helium), läßt sich leicht mit Quarzglas verschweißen und ist leicht zu reinigen. Es ist somit einfach handhabbar und erlaubt eine einfache und wirtschaftliche Herstellung eines UV-Sensors. Üblicherweise liegt das Streuelement in Form eines vor dem Fotodetektor angeordneten, selbständigen Bauteils vor. Es kann aber auch mit dem Fotodetektor fest verbunden sein.

Da das Streuelement keine Korngrenzen aufweist, hängen seine optischen Eigenschaften nicht oder nur unwesentlich von den Partikelgrößen der für ihre Herstellung eingesetzten Ausgangsmaterialien ab. Die optischen Eigenschaften des Streuelementes sind über sein gesamtes Volumen konstant, da es aus einem homogenen Material besteht. Die homogene Diffusivität des Streuelementes wird dadurch erreicht, daß das Quarzglas Grenzflächen aufweist, deren Orientierung im Raum statistisch homogen verteilt ist. Die statistisch homogene Verteilung erfordert eine sehr große Anzahl innerer Grenzflächen. Diese können beispielsweise durch zusammengesinterte feinverteilte Glassplitter oder durch eine große Anzahl feiner Poren erzeugt werden. Dadurch erscheint das Quarzglas opak und die Intensität des auf das Streuelement auftreffenden UV-Lichtes wird mit dem Cosinus des Einfallswinkels bewertet. Das bedeutet, daß, auch im stumpfen Winkel auf das Streuelement auftreffende Strahlung für die Messung berücksichtigt wird. Dies gewährleistet die gewünschte Richtungsunabhängigkeit der Messung.

Das Streuelement kann vollständig aus Quarzglas bestehen, wobei dieses aber nicht über die gesamte Dicke des Streuelementes diffus streuend sein muß. Als Dicke wird dabei die Abmessung des Streuelementes verstanden, die im wesentlichen senkrecht zum Lichtweg der UV-Strahlung verläuft.

Die Eintrittsöffung muß ein optisches Fenster für die UV-Strahlung bilden.Sie kann von einem UV-durchlässigen Element verschlossen sein, beispielsweise von dem Streuelement selbst, ohne dadurch ihre Eigenschaft als Eintrittsöffnug für die UV-Strahlung zu verlieren. Als Fotodetektoren kommen beispielsweise solche Empfänger in Frage, die die auftreffende Strahlung über die Zeit integrieren, als auch solche, die für jeden Zeitpunkt den aktuellen Meßwert der Strahlungsintesität aufnehmen und an eine Auswerteeinhait ausgeben.

Als vorteilhaft hat es sich erwiesen, den UV-Sensor mit einem Streuelement auszustatten, das geschlossene Poren aufweist. Hierzu werden Mikroporen, bei ansonsten dichten Glasgefüge, gezielt erzeugt. Besonders gute Ergebnisse werden erreicht mit Streuelementen aus Quarzglas mit Poren, deren Volumenanteil im Bereich zwischen 0,5 % und 10%, vorzugsweise bei weniger als 5 % liegt. Die Poren stellen Streuzentren dar. Sie verhindern die direkte Transmission des Lichtes, bewirken, daß ein hoher Anteil des einfallenden Lichtes ungerichtet gestreut wird und gewährleisten so die gewünschte Diffusivität des Streuelementes. Poren weisen eine geschlossene, typischerweise kugelförmige oder an die Kugelform angenäherte Oberfläche auf. Diese Oberflächen bilden innere Grenzflächen zwischen gasgefüllten oder leeren Hohlräumen und dem sie umgebenden Quarzglas. Jede Orientierung im Raum ist bei derartigen Oberflächen gleichermaßen wahrscheinlich. Die Orientierung im Raum ist daher statistisch homogen verteilt. Es gibt keine Vorzugsrichtung, wie sie bei kristallinem Material beobachtet werden kann. Aufgrund dieser Eigenschaft wird die Intensität des auf das Streuelement auftreffenden UV-Lichtes wird mit dem Cosinus des Einfallswinkels bewertet. Das bedeutet, daß, auch im stumpfen Winkel auf das Streuelement auftreffende Strahlung für die Messung berücksichtigt wird. Dies gewährleistet die gewünschte Richtungsunabhängigkeit der Messung. Für eine ausreichende Diffusivität ist ein Mindestgehalt an Poren um 0,5 Vol.-% erforderlich. Je größer der Volumenanteil der Poren ist, umso höher ist aber auch die Dämpfung des Streuelementes. Geschlossene Poren gewährleisten die Dichtigkeit der Streuscheibe und vermindern die Anfälligkeit gegenüber Verschmutzung.

Besonders gute Ergebnisse werden mit einem UV-Sensor erzielt, bei dem das Streuelement Poren enthält, von denen mindestens ein Anteil von 80% eine maximale Porenabmessung von weniger als 100 µm, vorzugsweise weniger als 10 µm, aufweist. Je kleiner die Porenabmessungen sind, umso kleiner sind die einzelnen Streuzentren, umso homogener ist die Diffusivität des Streuelementes über das Volumen verteilt. Dabei ist es besonders günstig, wenn die Größenverteilung der Poren möglichst schmal ist. Ein hoher Anteil an der gewünschten ungerichteten Streuung wird besonders dann erreicht, wenn die Porengröße im Bereich der Wellenlänge des zu messenden UV-Lichtes liegt.

Es wird eine Ausführungsform des UV-Sensor bevorzugt, bei dem das Streuelement einen SiO₂-Gehalt von mindestens 99,9 Gew.-% aufweist, wobei der Cristobalit-Gehalt höchstens 1 Gew.-% beträgt. Mit einem derartigen Streuelement werden besonders hohe mechanische Festigkeiten und eine sehr gute Strahlenbeständigkeit erzielt. So wurde bei der Bestrahlung derartiger Streuelemente mit UV-Stahlen im Wellenlängenbereich zwischen 300 nm und 400 nm kaum Solarisation festgestellt. Der niedrige Cristobalit-Gehalt gewährleistet eine hohe Lichtdurchlässigkeit und eine homogene Verteilung der optischen Eigenschaften, insbesondere der Streuung des UV-Lichtes über das gesamte Volumen der Streuscheibe.

Als besonders günstig hat es sich erweisen, einen UV-Sensors mit einem Streuelement auszubilden, das aus Quarzglas mit einer Dichte von mindestens 2,15 g/cm³ besteht. Ein derartiges Streuelement weist eine hohe mechanische und optische Festigkeit bei gleichzeitig guten Streueigenschaften und einer geringen Lichtdämpfung auf.

Insbesondere hinsichtlich einer einfachen Handhabung sowie einer guten Reproduzierbarkeit und Stabilität der Messung hat sich ein UV-Sensor bewährt, bei dem das Streuelement eine glatte Oberfläche ohne offene Poren aufweist. Ein derartiges Streuelement ist besonders unempfinlich gegenüber Verschmutzungen und gegebenenfalls leicht zu reinigen. Eine glatte Oberfläche läßt sich beispielsweise durch Flammenpolitur erreichen. Dabei wird gleichzeitig eine vollkommen transparente Oberflächenschicht erzeugt.

Es wird eine Ausführungsform des UV-Sensors bevorzugt, bei der das Streuelement die Eintrittsöffnung verschließt. Bei einem derartigen Sensor ist das Streuelement leicht zu montieren und gegebenenfalls auszutauschen. Es kann gasdicht mit dem Gehäuse verbunden sein. Die Ausführungsform gewährleistet eine hohe Meßgenauigkeit, da das zu messende UV-Licht unbehindert aus allen Richtungen unmittelbar auf das Streuelement fällt und von dort homogen, unter anderem auf den Fotodetektor, gestreut wird. Dabei kann das Streuelement auf das Gehäuse aufgesetzt sein, die Eintrittsöffnung also von außen verschließen. Sie kann die Eintrittsöffnug aber auch von innen verschließen, wobei jedoch in Kauf genommen werden muß, daß ein gewisser Winkelbereich der einfallenden Stahlung um 180° und um 0° (bezogen auf die Einfallsfläche des Fotodetektors) nicht erfaßt wird. Für einige Anwendungen kann aber auf die Erfassung dieser Winkelbereiche, deren Größe von der konkreten Anordnung des Streuelementes im Gehäuse abhängt, verzichtet werden.

Bei einer weiteren bevorzugten Ausführungsform des UV-Sensors bildet das Streuelement selbst das Gehäuse. Ein derartige Ausbildung wird durch die Nachbearbeitbarkeit des Quarzglas-Streumaterials ermöglicht. Das Gehäuse kann beispielsweise in Form einer den Fotodetektor überdeckenden Kappe aus einem Stück gefertigt sein. Das Gehäuse ist leicht gasdicht herstellbar und bietet den darin angeordneten Bauteilen sowohl Schutz vor chemischem Angriff als auch vor mechanischen Belastungen. Ein derartiger UV-Sensor ist leicht montierbar und wartungsfreundlich. Bei dieser Ausführungsform kann das gesamte Gehäuse als Eintrittsöffnung für die UV-Strahlung aufgefaßt werden.

Besonders bewährt hat sich ein UV-Sensor, bei dem zwischen dem Streuelement und dem Fotodetektor ein optisches Filter für sichtbares Licht angeordnet ist. Dadurch wird die Meßgenauigkeit eines UV-Sensors mit einem auch im Wellenlängenbereich des sichbaren Lichtes empfindlichen Fotodetektor im ultravioletten Spektralbereich erhöht. Das Filter kann als selbständiges Bauteil gestaltet sein. Es kann aber mit dem Streuelementes oder mit dem Fotodetektor, beispielsweise in Form einer Beschichtung, ausgebildet sein.

Als besonders vorteilhaft hat sich eine Ausführungsform des UV-Sensors erwiesen, bei dem die Eintrittsöffnung seitlich von einer Metallhülse, innerhalb der das Streuelement und mindestens der der Eintrittsöffnung zugewandte obere Teil des Fotodetektors angeordnet sind, begrenzt wird. Eine das Streuelement und den oberen Rand des Fotodetektors seitlich umschließende Metallhülse verhindert, daß Licht am Streuelement vorbei auf den Fotodetektor fällt und die Messung verfälscht. Eine Metalhülse, die auf der Innenseite reflektierend ausgebildet ist, trägt zur Lichtleitung vom Streuelement auf den Fotodetektor bei. Für den Fall, daß zwischen dem Streuelement und dem Fotodetektor ein Filter vorgesehen ist, wird auch diesesseitlich von der Metallhülse umschlossen.

Ausführungsbeispiele der Erfindung ist in der Zeichnung dargestellt und werden nachfolgend näher erläutert. In der Zeichnung zeigen im einzelnen in schematischer Darstellung:
- **Figur 1:**: einen möglichen eines UV-Sensors mit einer Streuscheibe,
- **Figur 2:**: eine weitere Ausführungsform eines erfindungsgemäßen UV-Sensors,
- **Figur 3:**: eine weitere Ausführungsform eines erfindungsgemäßen UV-Sensors,
- **Figur 4:**: eine weitere Ausführungsform eines erfindungsgemäßen UV-Sensors,
- **Figur 5:**: eine weitere Ausführungsform eines erfindungsgemäßen UV-Sensors und
- **Figur 6:**: den in Figur 5 markierten Bereich A in vergrößerter Darstellung

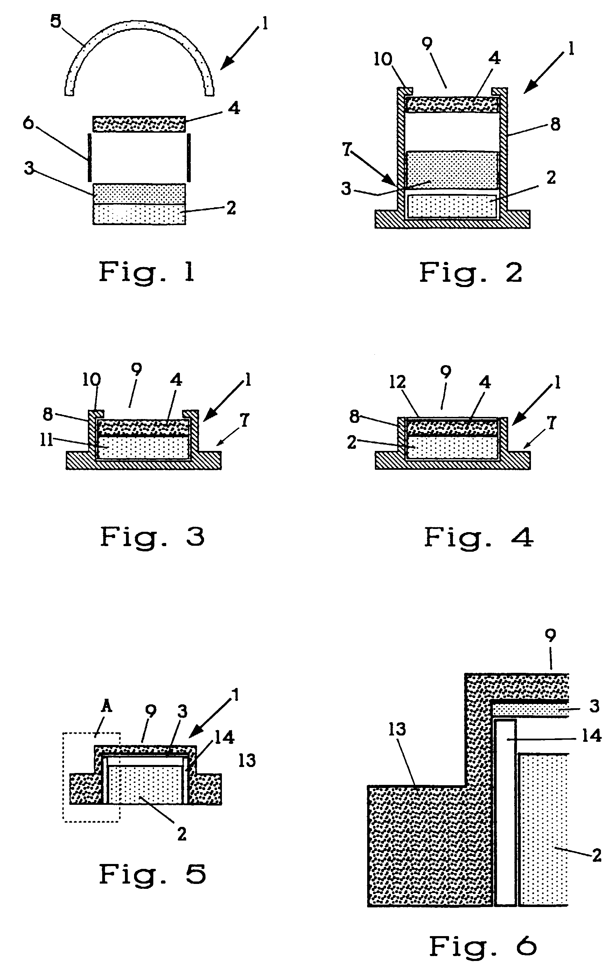

In Figur 1 ist die Bezugsziffer 1 dem UV-Sensor insgesamt zugeordnet. Der UV-Sensor 1 weist einen UV-Fotodetektor 2, einen Filter 3 für sichbares Licht und eine Streuscheibe 4 aus opakem, amorphem Quarzglas auf. Der Filter 3 ist zwischen dem Fotodetektor 2 und der Streuscheibe 4 angeordnet. Nach oben ist der UV-Sensor 1 von einem Quarzdom 5 abgeschlossen, der die Optik des Sensor 1 vor Beschädigungen schützt. Zu Verbesserung der Lichtführung zwischen der Streuscheibe 4 und dem Filter 3 ist zwischen diesen Bauteilen 3;4 eine innen reflektierend ausgebildete Stahlhülse 6 vorgesehen.

Die Streuscheibe 4 weist in diesem in in den folgenden Ausführungsbeispielen jeweils einen SiO₂-Gehalt von 99,94 Gew.-% auf, wobei der Cristobalit-Gehalt bei etwa 0,5 Gew.-% liegt. Ihre Opazität beruht auf geschlossenen Poren, deren Volumenanteil etwa 1 % beträgt und von denen ein Anteil von 80% eine maximale Porenabmessung von weniger als 3 µm, aufweisen. Die Dicke der Streuscheibe liegt üblicherweise im Bereich von 1 bis 2 mm. Ihre direkte Transmissivität für UV-Strahlung im Wellenlängenbereich zwischen 300 nm und 400 nm liegt bei einer Wandstärke von 1 mm bei etwa 10%. Der übrige Anteil des einfallenden Lichtes wird, abgesehen vom Dämpfungsanteil, in allen Raumrichtungen gestreut. Dadurch, wird eine homogene Diffusivität erreicht, so daß die Intensität des auf die Streuscheibe 4 auftreffenden UV-Lichtes mit dem Cosinus des Einfallswinkels bewertet wird. Dies gewährleistet die gewünschte Richtungsunabhängigkeit der Messung.

Da die Streuscheibe 4 aus amorphem Quarzglas, also aus einem homogenen Werkstoff ohne Korngrenzen besteht, weist sie eine hohe mechanische Festigkeit auf und ist maschinell bearbeitbar. Das Quarzglas gewährleistet eine hohe Strahlenbeständigkeit der Streuscheibe 4 gegenüber UV-Strahlung. Sie weist eine Dichte von ca. 2,18 g/cm³ sowie eine glatte Oberfläche, ohne offene Poren auf. Hierzu ist bei der Streuscheibe 4 ist mittlels Flammenpolitur eine transparente, porenfrei Oberflächenschicht erzeugt worden. Sie ist leicht zu reinigen, mit Quarzglas leicht zu verschweißen und, abgesehen von den durch Quarzglas hindurchdiffundierenden Gasen Helium und Wasserstoff, gasdicht. Sie ist somit einfach handhabbar und erlaubt eine einfache und wirtschaftliche Herstellung des UV-Sensors 1.

Bei der Ausführungsform des UV-Sensors 1 gemäß Figur 2 ist die Bezugsziffer 7 einem Gehäuse insgesamt zugeordnet. Das Gehäuse 7 weist einen hülsenförmigen Teil 8 aus Edelstahl auf, innerhalb dem ein Fotodetektor 2 und eine Streuscheibe 4 aus opakem, amorphem Quarzglas aufgenommen sind. Zwischen dem Fotodetektor 2 und der Streuscheibe 4 ist ein Filter 3 für sichtbares Licht vorgesehen. An ihrem dem Fotodetektor 2 abgwandten Ende weist die Edelstahlhülse 8 eine in der Eintrittsöffnung für die UV-Strahlung angeordnete Streuscheibe 4 auf. Die Streuscheibe 4 ist innerhalb der Stahlhülse 8, deren nach oben offenes Ende mit einem die Streuscheibe 4 teilweise überkragenden Rand 10 ausgebildet ist, angeordnet.

Der erfindungsgemäße UV-Sensor gemäß Figur 2 ist besonders gut für die Überwachung der UV-Strahlung in Bewitterungsgeräten geeignet.

Bei der Ausführungsform des erfindungsgemäßen Sensors nach Figur 3 ist innerhalb eines Gehäuses 7 aus Edelstahl eine Fotozelle 11 auf SiC-Basis und eine Streuscheibe 4 aus opakem, amorphem Quarzglas angeordnet. Das Gehäuse 7 weist einen innen reflektierenden, hülsenförmigen Teil 8 und, wie bei der Ausführungsform gemäß Figur 2 bereits erläutert, einen die Streuscheibe 4 teilweise überkragenden und die Eintrittsöffnung 9 definierenden Rand 10 auf. Die Streuscheibe 4 liegt unmittelbar auf der Fotozelle 11 auf. Am Rand können Fotozelle 11 und Streuscheibe 4 miteinander verklebt sein. Ein Filter für sichtbares Licht ist bei dieser Ausführungsform nicht erforderlich, da die Fotozelle 11 auf SiC-Basis sichtbares Licht nicht detektiert.

Bei der Ausführungsform des erfindungsgemäßen Sensors nach Figur 4 befinden sich innerhalb eines Gehäuses 7 aus Edelstahl eine Fotozelle 2 auf Si-Basis, eine Streuscheibe 4 aus opakem, amorphem Quarzglas und ein optisches Filter 12 für sichtbares Licht. Das Filter 12 besteht aus einer auf die Streuscheibe 4 aufgedampften dielektrischen Schicht aus Titanoxid. Das Gehäuse 7 weist wiederum einen innen reflektierenden, hülsenförmigen Teil 8 auf, dessen Rand in diesem Fall die Eintrittsöffnung 9 des UV-Sensors 1 definiert. Die Streuscheibe 4 liegt unmittelbar auf der Fotozelle 2 auf.

Bei der in Figur 5 dargestellten Ausführungsform des erfindungsgemäßen UV-Sensors ist das Streuelement in Form einer eine Fotozelle 2 und einen optischen Filter 3 umgebenden Streu-Kappe 13 ausgebildet. Die Kappe 13 besteht aus opakem, amorphem Quarzglas mit den Eigenschaften, sie wie im Zusammenhang mit der Ausführungsform gemäß Figur 1 bereits für die Streuscheibe 4 erläutert worden sind. Seine mechanische Nachbearbeitbarkeit, beispielsweise durch Sägen, Schleifen oder Bohren, ermöglicht die Herstellung einer derartigen Kappe 13 aus diffus streuendem Quarzglas. Die Kappe 13 ist aus einem Stück gefertigt; sie weist keine Fugen auf und ist daher leicht gasdicht herstellbar. Sie bietet den darin angeordneten Bauteilen sowohl Schutz vor chemischem Angriff als auch vor mechanischen Belastungen.

In der Vergrößerung des Ausschnitts A von Figur 5 in Figur 6 ist erkennbar, daß die das optische Filter 3 in Form einer SiO₂-Beschichtung auf der Innenseite der Kappe 13 aufgebracht ist, und zwar im Bereich der Eintrittsöffnung 9 für die UV-Strahlung. Die Eintrittsöffung 9 wird in diesem Ausführungsbeispiel durch ein lichtundurchlässiges und nach innen reflektierendes Metallrohr 14 seitlich begrenzt, innerhalb dem auch der Fotodetektor 2 angeordnet ist.

Nachfolgend wird ein Herstellungsverfahren für das Streuelement an einem Ausführungsbeispiel näher erläutert:

Formkörper zur Herstellung von Streuelementen für UV-Sensoren gemäß der Erfindung werden bevorzugt nach dem Schlickergießverfahren hergestellt. Ausführungsbeispiele für Herstellverfahren derartiger Formkörper werden im Deutschen Patent DE 43 38 807 erläutert. Die nach diesem Verfahren hergestellten Formkörper sind entweder direkt oder nach einer mechanischen oder chemischen Nachbehandlung als Streuelement, beispielsweise in Form einer Streuscheibe oder einer Streu-Kappe einsetzbar.

## Patentansprüche

1. UV-Sensor mit einem eine Eintrittsöffnung (9) für die UV-Strahlung aufweisenden Gehäuse (7,13), in dem ein Fotodetektor (2, 11) für die Messung der durch die Eintrittsöffnung (9) einfallenden UV-Strahlung angeordnet ist und mit einem, in Richtung der einfallenden UV-Strahlung vor aem Fotodetektor (2, 11) angeordnetem, SiO₂-haltigen Streuelement (4, 13), dadurch gekennzeichnet, daß das Streuelement (4, 13) Quarzglas enthält, mit inneren Grenzflächen, deren Orientierung im Raum statistisch homogen verteilt ist.

2. UV-Sensor nach Anspruch 1, dadurch gekennzeichnet, daß das Streuelement (4, 13) geschlossene Poren aufweist.

3. UV-Sensor nach Anspruch 2, dadurch gekennzeichnet, daß der Volumenanteil der Poren zwischen 0,5 % und 10 %, vorzugsweise weniger als 5 %, beträgt.

4. UV-Sensor nach einem der vorhergehenden Ansprüche, dadurch gekennzeichnet, daß das Streuelement (4, 13) Poren enthält, von denen mindestens ein Anteil von 80% eine maximale Porenabmessung von weniger als 100 µm, vorzugsweise weniger als 10 µm, aufweisen.

5. UV-Sensor nach einem der vorhergehenden Ansprüche, dadurch gekennzeichnet, daß das Streuelement (4, 13) einen SiO₂-Gehalt von mindestens 99,9 Gew.-% aufweist, wobei der Cristobalit-Gehalt höchstens 1 Gew.-% beträgt.

6. UV-Sensor nach einem der vorhergehenden Ansprüche, dadurch gekennzeichnet, daß das Streuelement (4, 13) eine Dichte von mindestens 2,15 g/cm³ aufweist.

7. UV-Sensor nach einem der vorhergehenden Ansprüche, dadurch gekennzeichnet, daß das Streuelement (4, 13) eine glatte Oberfläche, ohne offene Poren aufweist.

8. UV-Sensor nach einem der vorhergehenden Ansprüche, dadurch gekennzeichnet, daß das Streuelement (4) in Form einer Scheibe ausgebildet ist, die die Eintrittsöffnung (9) verschließt.

9. UV-Sensor nach einem der vorhergehenden Ansprüche, dadurch gekennzeichnet, daß das Streuelement (13) das Gehäuse bildet.

10. UV-Sensor nach einem der vorhergehenden Ansprüche, dadurch gekennzeichnet, daß zwischen dem Streuelement (4, 13) und dem Fotodetektor (2) ein optisches Filter (3) für sichtbares Licht angeordnet ist.

11. UV-Sensor nach einem der vorhergehenden Ansprüche, dadurch gekennzeichnet, daß die Eintrittsöffnung (9) seitlich von einer Stahlhülse (10) begrenzt wird, innerhalb der das Streuelement (4, 13) und mindestens der der Eintrittsöffnung (9) zugewandte obere Teil des Fotodetektors (2) angeordnet sind.

## Claims

1. A UV sensor comprising a housing (7, 13) which has an inlet opening (9) for the UV radiation and in which there is arranged a photodetector (2, 11) for measuring the UV radiation entering through the inlet opening (9), and comprising a scattering element (4, 13) which contains SiO₂ and is arranged before the photodetector (2, 11) in the direction of the incident UV radiation, characterised in that the scattering element (4, 13) contains quartz glass with inner boundary surfaces whose spatial orientation is statistically homogeneously distributed.

2. A UV sensor according to Claim 1, characterised in that the scattering element (4, 13) has closed pores.

3. A UV sensor according to Claim 2, characterised in that the volume percentage of the pores amounts to between 0.5% and 10%, preferably less than 5%.

4. A UV sensor according to one of the preceding claims, characterised in that the scattering element (4, 13) contains pores, of which at least a proportion of 80% have a maximum pore size of less than 100 µm, preferably less than 10 µm.

5. A UV sensor according to one of the preceding claims, characterised in that the scattering element (4, 13) has a SiO₂ content of at least 99.9 wt.%, the cristobalite content amounting at the maximum to 1 wt.%.

6. A UV sensor according to one of the preceding claims, characterised in that the scattering element (4, 13) has a density of at least 2.15 g/cm²

7. A UV sensor according to one of the preceding claims, characterised in that the scattering element (4, 13) has a smooth surface without open pores.

8. A UV sensor according to one of the preceding claims, characterised in that the scattering element (4) is constructed in the form of a disc which closes the inlet opening (9).

9. A UV sensor according to one of the preceding claims, characterised in that the scattering element (13) forms the housing.

10. A UV sensor according to one of the preceding claims, characterised in that an optical filter (3) for visible light is arranged between the scattering element (4, 13) and the photodetector (2).

11. A UV sensor according to one of the preceding claims, characterised in that the inlet opening (9) is laterally delimited by a steel sleeve (10) inside which are arranged the scattering element (4, 13) and at least the upper part of the photodetector (2) facing towards the inlet opening (9).

## Revendications

1. Capteur UV comprenant un boîtier (7, 13) possédant une ouverture d'entrée (9) pour le rayonnement UV, dans lequel est disposé un photodétecteur (2, 11) pour la mesure du rayonnement UV pénétrant par l'ouverture d'entrée (9) et comprenant un élément de dispersion (4, 13) contenant SiO₂, disposé avant le photodétecteur (2, 11) dans la direction du rayonnement UV incident, caractérisé en ce que l'élément de dispersion (4, 13) contient du verre quartzeux, avec des surfaces limites dont l'orientation dans l'espace est répartie de manière statistiquement homogène.

2. Capteur UV selon la revendication 1, caractérisé en ce que l'élément de dispersion (4, 13) présente des pores fermés.

3. Capteur UV selon la revendication 2, caractérisé en ce que la fraction volumique des pores est comprise entre 0,5 % et 10 %, et de préférence inférieure à 5 %.

4. Capteur UV selon l'une des revendications précédentes, caractérisé en ce que l'élément de dispersion (4, 13) contient des pores parmi lesquels au moins une proportion de 80 % présente une dimension de pore maximale inférieure à 100 µm, de préférence inférieure à 10 µm.

5. Capteur UV selon l'une des revendications précédentes, caractérisé en ce que l'élément de dispersion (4, 13) présente une teneur en SiO₂ d'au moins 99,9 % en poids, la teneur en cristobalite étant au plus de 1 % en poids.

6. Capteur UV selon l'une des revendications précédentes, caractérisé en ce que l'élément de diffusion (4, 13) présente une masse volumique d'au moins 2,15 g/cm³.

7. Capteur UV selon l'une des revendications précédentes, caractérisé en ce que l'élément de diffusion (4, 13) présente une surface lisse sans pores ouverts.

8. Capteur UV selon l'une des revendications précédentes, caractérisé en ce que l'élément de diffusion (4) est réalisé sous la forme d'une plaque qui obture l'ouverture d'entrée (9).

9. Capteur UV selon l'une des revendications précédentes, caractérisé en ce que l'élément de diffusion (13) forme le boîtier.

10. Capteur UV selon l'une des revendications précédentes, caractérisé en ce qu'un filtre optique (3) pour la lumière visible est disposé entre l'élément de diffusion (4, 13) et le photodétecteur (2).

11. Capteur UV selon l'une des revendications précédentes, caractérisé en ce que l'ouverture d'entrée (9) est limitée latéralement par une douille d'acier (10) à l'intérieur de laquelle sont disposés l'élément de diffusion (4, 13) et au moins la partie supérieure du photodétecteur (2) tournée vers l'ouverture d'entrée (9).
